# EUROPÄISCHE PATENTSCHRIFT

(11) **EP 3 657 543 B1**
(45) Veröffentlichungstag und Bekanntmachung des Hinweises auf die Patenterteilung: **04.01.2023**
(21) Anmeldenummer: 19206551.4
(22) Anmeldetag: 31.10.2019
(51) Int. Cl.: H01L 27/01, H01L 49/02, H01L 29/66, H01L 29/94, H01L 27/07

(54) **RC-SNUBBERGLIED MIT HOHER SPANNUNGSFESTIGKEIT**
RC SNUBBER HAVING HIGH ELECTRIC STRENGTH
ÉLÉMENT AMORTISSEUR RC À RIGIDITÉ DIÉLECTRIQUE ÉLEVÉE

(30) Priorität: 22.11.2018 DE 102018219994
(43) Veröffentlichungstag der Anmeldung: 27.05.2020
(73) Patentinhaber: Fraunhofer-Gesellschaft zur Förderung der angewandten Forschung e.V., 80686 München (DE)
(72) Erfinder: ERLBACHER, Tobias, 91058 Erlangen (DE); SCHLETZ, Andreas, 91058 Erlangen (DE); RATTMANN, Gudrun, 91058 Erlangen (DE)
(74) Vertreter: Gagel, Roland

(56) Entgegenhaltungen:
- EP-A2- 1 845 620
- DE-A1-102014 200 869
- US-A1- 2012 012 982
- VOM DORP J ET AL: "Monolithic RC-snubber for power electronic applications", POWER ELECTRONICS AND DRIVE SYSTEMS (PEDS), 2011 IEEE NINTH INTERNATIONAL CONFERENCE ON, IEEE, 5. Dezember 2011 (2011-12-05), Seiten 11-14, XP032112322, DOI: 10.1109/PEDS.2011.6147217 ISBN: 978-1-61284-999-7

## Beschreibung

### Technisches Anwendungsgebiet

Die vorliegende Erfindung betrifft eine elektrische Schaltungsanordnung aus einem monolithisch in ein Halbleitersubstrat integrierten RC-Snubberglied, bei der ein erster Kondensator und ein Widerstand des RC-Snubberglieds vertikal in einem Halbleitergebiet eines ersten Dotierungstyps des Halbleitersubstrats ausgebildet sind und wenigstens ein weiterer Kondensator in Reihe mit dem ersten Kondensator verschaltet ist.

Snubber-Glieder werden in elektrischen Schaltungen eingesetzt, um störende Hochfrequenzen oder Spannungsspitzen zu dämpfen, wie sie bspw. beim Schalten induktiver Lasten auftreten. Häufig werden hierzu so genannte RC-Snubberglieder genutzt, die durch eine Reihenschaltung eines Kondensators mit einem Widerstand gebildet sind. Für einen Einsatz in der Leistungselektronik werden niederinduktive Snubberglieder benötigt, die eine gute Entwärmbarkeit und eine hohe Spannungsfestigkeit aufweisen.

### Stand der Technik

Die monolithische Integration eines vertikalen RC-Snubberglieds in ein Halbleitersubstrat erlaubt eine hohe Entwärmbarkeit. Ein derartiges RC-Snubberglied ist beispielsweise in der US 7 738 226 B2 beschrieben. Der Kondensator dieses RC-Snubberglieds wird durch eine Grabenstruktur in einem Halbleitersubstrat gebildet, die mit einer dielektrischen Schicht beschichtet und mit einem elektrisch leitfähigen Material aufgefüllt ist. Ein dotierter Bereich zwischen dieser Grabenstruktur und der Rückseite des Substrats bildet den Widerstand des RC-Snubberglieds. Durch geeignete Kontaktmetallisierung auf der Vorder- und der Rückseite wird die Kontaktierung des RC-Snubberglieds ermöglicht. Der dadurch erhaltene RC-Snubberchip kann beispielsweise auf einem DCB-Substrat (DCB: Direct Copper Bonding) montiert werden. Allerdings erfordert eine hohe Spannungsfestigkeit eines derartigen RC-Snubberglieds von beispielsweise 1200V ein sehr dickes Dielektrikum, mit den damit verbundenen Problemen mechanischer Spannungen.

Eine Serienschaltung von zwei RC-Snubbergliedern auf einem DCB-Substrat würde die Spannungsbelastung jedes RC-Snubberglieds zwar auf die Hälfte reduzieren. Dies erfordert jedoch zwei oberseitige Bondstellen und führt dadurch zu einer erhöhten Induktivität. Außerdem benötigt eine derartige Anordnung zusätzlichen Flächenbedarf aufgrund der erforderlichen Luftstrecke zwischen den Einzelbauelementen.

Die Spannungsbelastung von Kondensatoren kann durch Reihenschaltung mehrerer Kondensatoren verringert werden. So wird beispielsweise in der US 9 917 146 B2 und der DE 10 2014 200 869 A1 eine vertikale Anordnung monolithisch integrierter Kondensatoren vorgeschlagen, bei denen der erste Kondensator als Grabenstruktur an der Vorderseite des Halbleitersubstrats und der zweite Kondensator als Grabenstruktur an der Rückseite des Halbleitersubstrats ausgebildet ist. Eine derartige Realisierung ist durch beidseitige Prozessierung des Halbleitersubstrats möglich. Allerdings entspricht in diesem Fall das Rückseitenpotential nicht dem Substratpotential. Für den Modulaufbau ist bei einer solchen Ausgestaltung außerdem ein erhöhter Isolationsaufwand erforderlich.

In der US 2008/0017920 A1 ist ein Shielded-Gate-Feldeffekttransistor in vertikaler Bauweise beschrieben, der mehrere parasitäre Kapazitäten aufweist. Bei diesem Transistor ist ein Widerstandselement zwischen der Shield-Elektrode und einem Source-Bereich des Transistors ausgebildet, durch das der Reverse-Recovery-Verlust verringert wird.

Aus der US 2016/0118380 A1 ist eine MOSFET-Struktur mit einem oder mehreren RC-Snubber-Gliedern bekannt, bei denen der Widerstand über Änderung am Gate- und/oder Drain-Potential des oder der MOSFETs dynamisch kontrolliert werden kann.

Die Aufgabe der vorliegenden Erfindung besteht darin, eine elektrische Schaltungsanordnung aus einem RC-Snubberglied anzugeben, die eine geringe Induktivität bei guter Entwärmbarkeit, hoher Spannungsfestigkeit und hoher Integrationsdichte aufweist.

### Darstellung der Erfindung

Die Aufgabe wird mit der elektrischen Schaltungsanordnung gemäß Patentanspruch 1 gelöst. Vorteilhafte Ausgestaltungen der Schaltungsanordnung sind Gegenstand der abhängigen Patentansprüche oder lassen sich der nachfolgenden Beschreibung sowie dem Ausführungsbeispiel entnehmen.

Bei der vorgeschlagenen elektrischen Schaltungsanordnung ist das RC-Snubberglied in ein Halbleitersubstrat integriert, wobei ein erster Kondensator und der Widerstand des RC-Snubberglieds vertikal in einem Halbleitergebiet eines ersten Dotierungstyps des Halbleitersubstrats ausgebildet sind. Wenigstens ein weiterer Kondensator ist in Reihe mit dem ersten Kondensator verschaltet. Dieser weitere Kondensator ist lateral zum ersten Kondensator in ein Halbleitergebiet eines zweiten Dotierungstyps integriert, das an das Halbleitergebiet des ersten Dotierungstyps angrenzt. Durch die unterschiedlichen Dotierungstypen wird dieser weitere Kondensator vom Halbleitergebiet des ersten Dotierungstyps und damit dem Widerstand des RC-Snubberglieds über einen pn-Übergang elektrisch isoliert.

Die vorgeschlagene elektrische Schaltungsanordnung zeichnet sich somit durch eine Kombination eines vertikalen und wenigstens eines lateralen Kondensators in dem Halbleitersubstrat aus, so dass für die vorderseitige Kontaktierung lediglich ein Bonddraht erforderlich ist. Dies führt zu einer geringen Induktivität dieser als RC-Snubberglied wirkenden Schaltungsanordnung. Durch die monolithische Integration genau eines vertikalen RC-Snubbers werden weiterhin thermische Verluste über das Halbleitersubstrat abgeführt, so dass eine gute Entwärmbarkeit der Schaltungsanordnung gewährleistet ist. Auch der Widerstand des RC-Snubberglieds ist weiterhin über die Dotierung zwischen dem ersten Kondensator und der Rückseite des Halbleitersubstrats im Halbleitergebiet des ersten Dotierungstyps einstellbar. Das Rückseitenpotential an einer auf der Rückseite aufgebrachten Metallisierung zur Kontaktierung des Widerstands entspricht dem Substratpotential.

Durch die Anordnung eines weiteren Kondensators als lateraler Kondensator wird die Sperrspannung der elektrischen Schaltungsanordnung auf mehrere Kondensatoren aufgeteilt. Dadurch kann ein dünneres Dielektrikum in den Kondensatoren eingesetzt werden, so dass auch geringerer mechanischer Stress auftritt. So kann das Dielektrikum vorzugsweise eine Dicke zwischen 500nm und 2000nm aufweisen, um bei einer Reihenschaltung des vertikalen mit einem lateralen Kondensator eine Spannungsfestigkeit zwischen etwa 400V und etwa 2000V zu erreichen. Beispielsweise ergibt eine Schichtdicke von 20nm SiO₂ und 500nm Si₃N₄ eine Spannungsfestigkeit von 400V, eine Schichtdicke von 330nm SiO₂ und 1000nm Si₃N₄ eine Spannungsfestigkeit von 1200V und eine Schichtdicke von 330nm SiO₂ und 1500nm Si₃N₄ eine Spannungsfestigkeit von 1800V. Bei mehr als einem lateralen Kondensator erniedrigt sich die erforderliche Schichtdicke entsprechend. Bei gleichbleibender Schichtdicke erhöht sich entsprechend die Spannungsfestigkeit.

Die Isolation des einen oder der mehreren lateralen Kondensatoren erfolgt durch pn-Übergänge, die bei geeigneter Polarität der elektrischen Spannung am RC-Snubberglied als Dioden in Sperrrichtung wirken. Der pn-Übergang zwischen den Halbleitergebieten des unterschiedlichen Dotierungstyps muss dabei nur etwa 50% der anliegenden Spannung sperren. Die vorgeschlagene Schaltungsanordnung ermöglicht auch eine höhere Integrationsdichte gegenüber einer Ausgestaltung mit nur einem Kondensator und gleicher Spannungsfestigkeit, für den aufgrund eines dickeren Dielektrikums nur eine geringere Lochtiefe möglich ist und damit für die gleiche Kapazität eine größere Fläche benötigt wird.

In der bevorzugten Ausgestaltung ist das Halbleitergebiet des zweiten Dotierungstyps, in dem der weitere Kondensator ausgebildet ist, als Wannengebiet in dem Halbleitergebiet des ersten Dotierungstyps ausgebildet. Bei Reihenschaltung mehrerer lateraler Kondensatoren sind dann vorzugsweise mehrere voneinander getrennte Wannengebiete des zweiten Dotierungstyps in dem Halbleitergebiet des ersten Dotierungstyps ausgebildet.

Vorzugsweise erstreckt sich das Halbleitergebiet des ersten Dotierungstyps von der Vorderseite des Halbleitersubstrats, an der die Kondensatoren ausgebildet sind, bis zur Rückseite des Halbleitersubstrats. Die Rückseite ist dabei mit einer Rückseitenmetallisierung versehen, über die der Widerstand des RC-Snubberglieds elektrisch kontaktierbar ist. An der Vorderseite ist wenigstens ein elektrischer Kontakt aufgebracht, über den wenigstens der weitere Kondensator bzw. - bei mehreren weiteren Kondensatoren - der letzte Kondensator der Reihenschaltung elektrisch kontaktierbar ist.

Die Kondensatoren sind bei der vorgeschlagenen Schaltungsanordnung bevorzugt in bekannter Weise jeweils durch eine Anordnung von Vertiefungen in der Vorderseite des Halbleitersubstrats gebildet, die mit einer elektrisch isolierenden dielektrischen Schicht oder Schichtfolge beschichtet und mit einem elektrisch leitfähigen Material aufgefüllt sind. Die Vertiefungen können beispielsweise als nebeneinander verlaufende Gräben, insbesondere in paralleler oder auch in konzentrischer Anordnung, ausgebildet sein. Vorzugsweise werden als Vertiefungen Lochstrukturen in hexagonaler Anordnung verwendet. Auch andere Geometrien wie beispielsweise an der Oberfläche im Querschnitt rechteckförmige Vertiefungen sind möglich. Vorzugsweise weisen hierbei alle Kondensatoren ein gemeinsames Dielektrikum bzw. eine gemeinsame dielektrische Schicht oder Schichtfolge auf. Dieses Dielektrikum kann beispielsweise aus Siliziumdioxid und Siliziumnitrid gebildet sein.

Bei der vorgeschlagenen Schaltungsanordnung können zwischen den Kondensatoren Symmetrierwiderstände entweder als ohmsche oder auch als nichtlineare Widerstände (weitere Diodenstrukturen) ausgebildet sein, um die Leckströme der durch die pn-Übergänge gebildeten pn-Dioden zu symmetrieren. Weiterhin kann um die Wannengebiete für die weiteren Kondensatoren auch jeweils ein Randabschluss für den sperrenden pn-Übergang ausgebildet sein.

Die Halbleitergebiete im Bereich der Kondensatoren werden vorzugsweise ausreichend hoch dotiert, um einen niedrigen ESR (ESR: Ersatzserienwiderstand) zu erreichen.

Die vorgeschlagene Schaltungsanordnung lässt sich sehr vorteilhaft zur Spannungsdämpfung und für ähnliche Anwendungen von RC-Snubbergliedern in der Leistungselektronik einsetzen. Sie lässt sich als Halbleiterchip auf einfache Weise auf Leistungshalbleitersubstraten, insbesondere auf DCB-Substraten, montieren. Aufgrund der großen thermischen Kontaktfläche über die Rückseite des Halbleiterchips wird eine sehr gute Entwärmbarkeit erreicht.

### Kurze Beschreibung der Zeichnungen

Die vorgeschlagene elektrische Schaltungsanordnung wird nachfolgend anhand von Ausführungsbeispielen in Verbindung mit den Zeichnungen nochmals näher erläutert. Hierbei zeigen:
- Fig. 1: einen Querschnitt durch eine elektrische Schaltungsanordnung sowie ein Ersatzschaltbild gemäß einem ersten Ausführungsbeispiel der vorliegenden Erfindung;
- Fig. 2: einen Querschnitt durch eine elektrische Schaltungsanordnung sowie ein Ersatzschaltbild gemäß einem zweiten Ausführungsbeispiel der vorliegenden Erfindung;
- Fig. 3: einen Querschnitt durch eine elektrische Schaltungsanordnung sowie ein Ersatzschaltbild gemäß einem dritten Ausführungsbeispiel der vorliegenden Erfindung;
- Fig. 4: einen Querschnitt durch eine elektrische Schaltungsanordnung sowie ein Ersatzschaltbild gemäß einem vierten Ausführungsbeispiel der vorliegenden Erfindung;
- Fig. 5: zwei Beispiele für die Anordnung des vertikalen und eines oder mehrerer lateraler Kondensatoren in einer Draufsicht auf die elektrische Schaltungsanordnung gemäß der vorliegenden Erfindung;
- Fig. 6: einen Querschnitt durch eine elektrische Schaltungsanordnung sowie ein Ersatzschaltbild gemäß einem fünften Ausführungsbeispiel der vorliegenden Erfindung; und
- Fig. 7A-D: eine beispielhafte Abfolge der Verfahrensschritte zur Herstellung der vorgeschlagenen elektrischen Schaltungsanordnung in Querschnittsdarstellung.

### Wege zur Ausführung der Erfindung

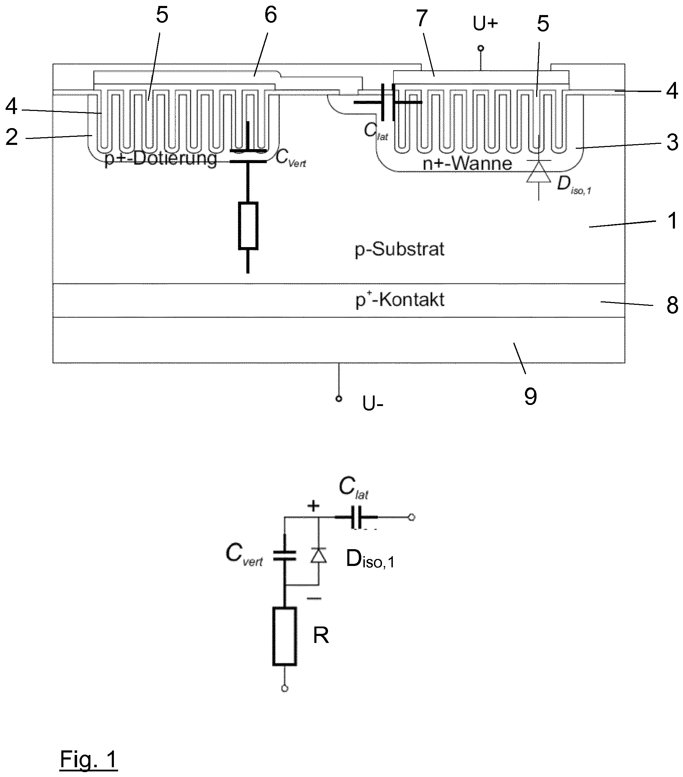

Im Folgenden wird die vorgeschlagene elektrische Schaltungsanordnung anhand mehrerer Ausführungsbeispiele näher beschrieben, bei denen das RC-Snubberglied mit dem vertikalen und dem einen oder den mehreren lateralen Kondensator(en) als Halbleiterchip ausgebildet ist. Figur 1 zeigt hierzu eine Querschnittsdarstellung eines ersten Ausführungsbeispiels, sowie ein zugehöriges Ersatzschaltbild dieser Ausgestaltung. Das RC-Snubberglied ist hierbei durch eine Reihenschaltung eines Widerstands R, eines vertikalen Kondensators Cᵥₑᵣₜ sowie eines lateralen Kondensators Cₗₐₜ gebildet, wie dies aus dem Ersatzschaltbild ersichtlich ist. Hierzu sind in die Vorderseite des p-dotierten Halbleitersubstrates 1 eine p+-dotierte Wanne 2 sowie eine n+-dotierte Wanne 3 eingebracht. In diesen Wannen sind Gräben ausgebildet, die mit einer dielektrischen Schicht 4 beschichtet und mit einem elektrisch leitfähigen Material 5, beispielsweise mit Polysilizium, verfüllt sind. Die beiden hierdurch gebildeten Kondensatoren sind über eine Metallisierung 6 in Reihe miteinander verbunden, wobei der laterale Kondensator Cₗₐₜ über eine entsprechende vorderseitige Elektrode 7 elektrisch kontaktierbar ist. An der Rückseite des Halbleitersubstrats 1 befindet sich eine p+-Schicht zur Bildung eines p+-Kontakts 8, auf den eine Rückseitenmetallisierung 9 aufgebracht ist. Diese Rückseitenmetallisierung bildet die rückseitige Elektrode zur Kontaktierung des RC-Snubberglieds. Durch die n+-Dotierung des Wannengebiets 3 des lateralen Kondensators Cₗₐₜ wird eine pn-Diode D_{iso,1} gebildet, wie dies im Ersatzschaltbild ersichtlich ist. Die einzelnen Bauelemente dieses Ersatzschaltbilds sind ebenfalls in der Querschnittsdarstellung angedeutet. Die Polarität der Kondensatoren ist durch eine Sperrpolung der pn-Diode D_{iso,1} vorgegeben. Durch die p-Dotierung des Halbleitersubstrats 1 und die Dicke dieses Substrats wird die Größe des Widerstands R vorgegeben bzw. einstellbar.

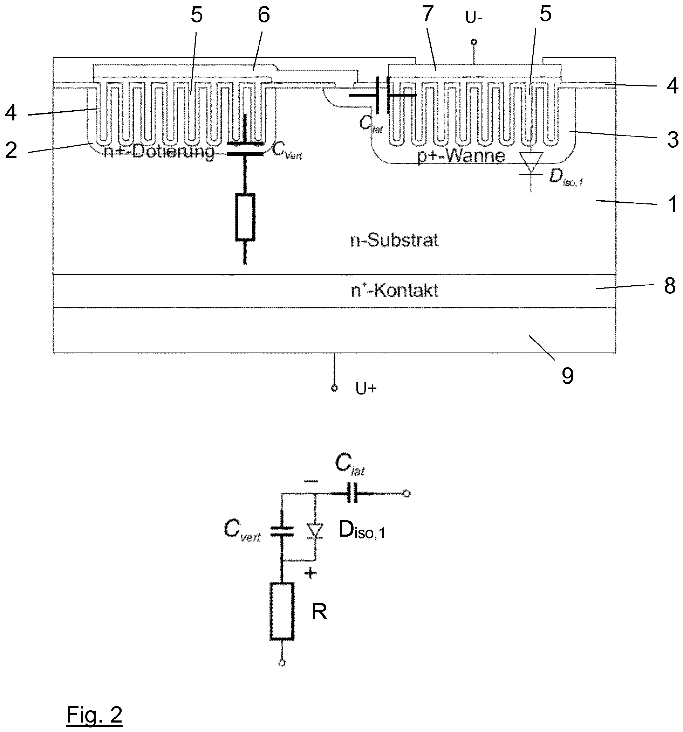

Eine derartige elektrische Schaltungsanordnung lässt sich auch mit gegenüber der Figur 1 invertierten Dotierungen realisieren, wie dies schematisch in Figur 2 in Querschnittsdarstellung sowie im zugehörigen Ersatzschaltbild dargestellt ist.

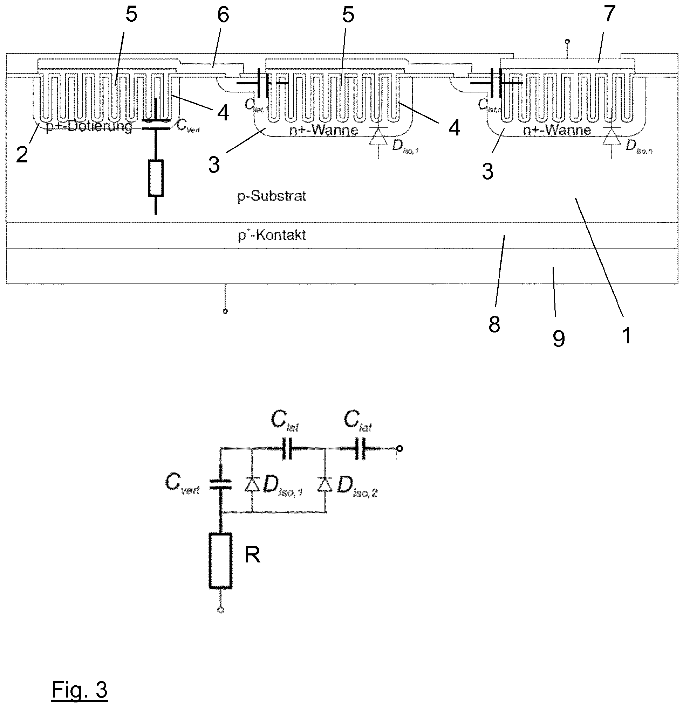

Die vorgeschlagene elektrische Schaltungsanordnung lässt sich auch mit mehr als einem lateralen Kondensator realisieren. In diesem Fall sind dann mehrere laterale Kondensatoren Cₗₐₜ in Reihe zum vertikalen Kondensator Cᵥₑᵣₜ verschaltet, wie dies beispielhaft mit zwei lateralen Kondensatoren Cₗₐₜ in der Figur 3 angedeutet ist. Der zweite laterale Kondensator ist hierbei in gleicher Weise wie der erste laterale Kondensator in einer n⁺-dotieren Wanne 3 im Halbleitersubstrat ausgebildet. Die Verbindung der einzelnen Kondensatoren erfolgt auch hier über entsprechende Metallisierungen 6. Die Sperrfestigkeit der pn-Diode D_{iso,2} bzw. D_{iso,n} des letzten lateralen Kondensators in der Reihenschaltung muss hinreichend hoch sein, um die auftretenden Spannungen auszuhalten.

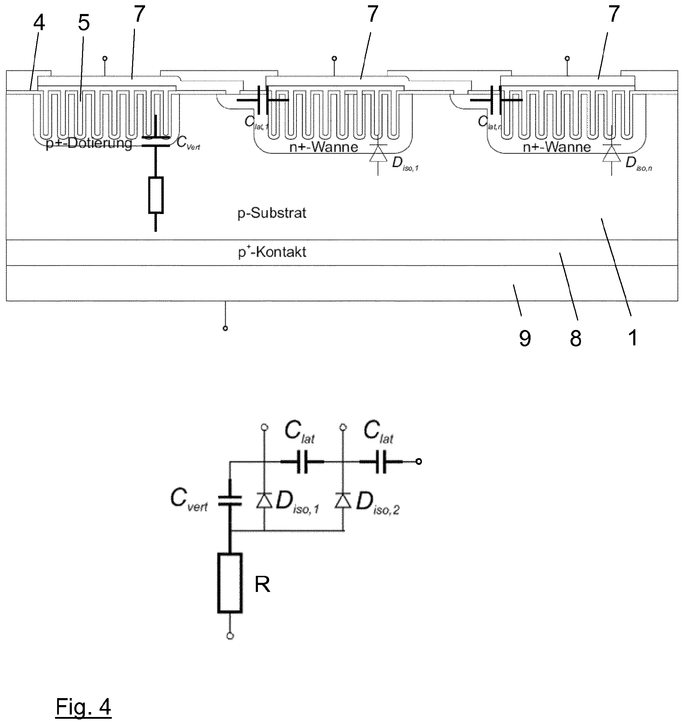

Anstelle der Kontaktierung nur des letzten Kondensators in der Reihenschaltung kann in einer Ausgestaltung auch jeder der Kondensatoren Cᵥₑᵣₜ, Cₗₐₜ mit einer entsprechenden Kontaktelektrode 7 versehen sein, wie dies beispielshaft in der Querschnittsdarstellung und im Ersatzschaltbild der Figur 4 dargestellt ist. Durch diese Möglichkeit der Kontaktierbarkeit der einzelnen Kondensatoren kann beispielsweise eine Ladungspumpe oder ein kapazitiver Spannungsteiler realisiert werden. Die einzelnen Kondensatoren können hierbei auch unterschiedliche Kapazitätswerte aufweisen.

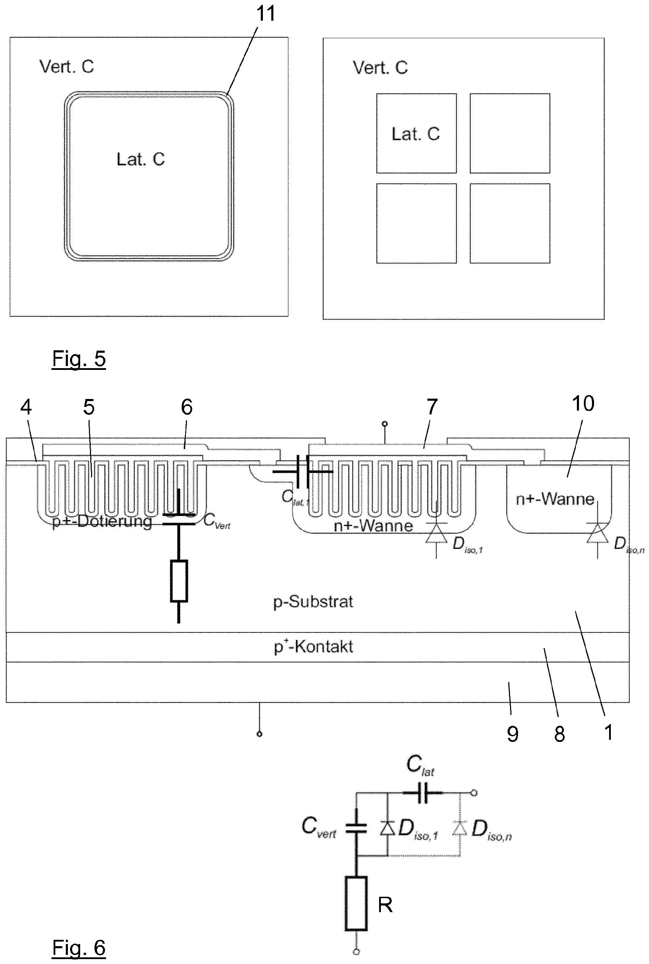

Die einzelnen Kondensatoren können in unterschiedlicher Weise lateral angeordnet sein. Figur 5 zeigt hierzu zwei Beispiele einer derartigen Anordnung in Draufsicht auf das Halbleitersubstrat stark schematisiert. In der linken Ausgestaltung mit nur einem lateralen Kondensator Cₗₐₜ ist dieser symmetrisch innerhalb des Gebiets des vertikalen Kondensators Cᵥₑᵣₜ angeordnet. In dieser Figur ist auch Randabschluss 11 angedeutet, der einen Durchbruch an den Krümmungen der Wanne für den lateralen Kondensator verhindern soll. Der Randabschluss stellt eine Sperrschichtisolation der pn-Dioden mit Hilfe von Feldringen dar. Im rechten Teil der Figur ist eine Ausgestaltung mit vier lateralen Kondensatoren beispielhaft angedeutet.

Figur 6 zeigt schließlich noch ein weiteres Ausführungsbeispiel der vorgeschlagenen elektrischen Schaltungsanordnung, bei der zusätzlich noch eine n+-Wanne 10 in das Halbleitersubstrat 1 eingebracht ist, um eine zusätzliche pn-Diode D_{iso,n} zu erzeugen. Auch eine Reihenschaltung von entsprechenden Zenerdioden für hohe Spannungen zur Symmetrierung ist bei der vorgeschlagenen Schaltungsanordnung möglich. Die Auslegung der Leckströme der einzelnen pn-Dioden kann über die jeweiligen Bauelementflächen erfolgen. Auch das Einbringen zusätzlicher Poly-Widerstände zwischen den einzelnen Kondensatoren ist zur Symmetrierung möglich.

Die Sperrfestigkeit der jeweiligen pn-Diode kann über die Dotierungen und die Weite des Driftgebietes (Substratdicke) eingestellt werden. Hierbei ist eine vertikale Ausdehnung entsprechend einer Substratdicke von > 200 µm bevorzugt. Die laterale Ausdehnung, d.h. die Abstände zwischen den einzelnen Kondensatoren in lateraler Richtung, kann bei geeigneter Einstellung der Dotierungen zur Vermeidung eines PT-Effektes < 200 µm betragen.

Die folgende Tabelle gibt ein Beispiel für den möglichen Widerstandsbereich (jeweiliger Mindestwiderstand) für unterschiedliche Spannungen bei einer Substratdicke von 650 µm an.

| | | | | | | | | | |
|---|---|---|---|---|---|---|---|---|---|
| R in Ωcm² | 0,03 | 0,07 | 0,16 | 0,7 | 1,2 | 1,8 | 2,9 | 4,2 | 6,8 |
| *Uₘₐₓ* in V | 50 | 100 | 200 | 600 | 900 | 1200 | 1700 | 2300 | 3300 |

Durch entsprechend dünnere Substrate bzw. Epitaxie sind auch geringere Widerstände möglich.

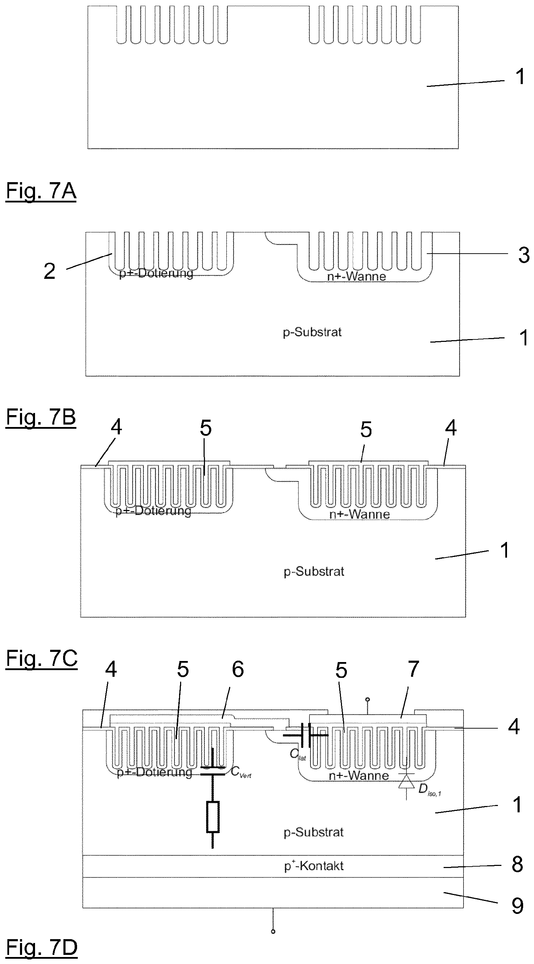

Im Folgenden wird ein Beispiel für die Herstellung einer erfindungsgemäßen elektrischen Schaltungsanordnung mit einem vertikalen und einem lateralen Kondensator gemäß Figur 1 kurz erläutert. Zunächst wird in die Oberfläche des Substrats 1 mit Hilfe einer Maske jeweils eine Grabenstruktur für die beiden Kondensatoren erzeugt. Dies dient der Oberflächenvergrößerung für die Bildung der Kondensatoren und kann beispielsweise bei einem Siliziumsubstrat mittels Trockenätzen (anisotrop) erfolgen. Figur 7A zeigt hierzu eine entsprechende Grabenstruktur des p-dotierten Halbleitersubstrats 1. Anschließend erfolgt eine Dotierung der Kondensatorgebiete zur Erzeugung der jeweiligen Wannen 2, 3. Die Wanne 2 für den vertikalen Kondensator wird hierbei p+-dotiert, beispielsweise durch B-Implantation oder Borglasabscheidung. Die n+-Dotierung der Wanne 3 für den lateralen Kondensator kann beispielsweise durch P-Implantation oder POCl₃-Abscheidung erfolgen. Anschließend erfolgt das Ausheilen, bei dem die Dotierstoffe aktiviert und die Oberflächenkonzentration reduziert werden. Figur 7B zeigt das Ergebnis dieses Dotierungsschrittes im Querschnitt. Zusätzlich ist auch eine Implantation eines Randabschlusses für die n+-dotierte Wanne 3 möglich. Im nächsten Schritt erfolgt die Abscheidung des Kondensatordielektrikums 4 und die Auffüllung der Gräben mit Polysilizium 5, wie dies in Figur 7C schematisch angedeutet ist. Das Kondensatordielektrikum 4 wird durch thermische Oxidation in Verbindung mit einer Siliziumnitrid-Abscheidung erzeugt. Anschließend folgt die Polysilizium-Abscheidung (z.B. in-situ dotiert) und die Strukturierung der abgeschiedenen Schicht. Schließlich erfolgt noch eine Kontaktlochätzung für die spätere elektrische Kontaktierung. In Figur 7D sind die abschließende Elektrodenherstellung und Passivierung dargestellt. Zunächst erfolgt eine Metallisierung der Vorderseite in Verbindung mit einer Strukturierung des Metalls 6 und des Polysiliziums 5. Anschließend erfolgen die Metallisierung der Rückseite und die Abscheidung einer Passivierung, beispielsweise mit Polyimid. Als Ergebnis wird eine elektrische Schaltungsanordnung erhalten, wie sie in Figur 1 beschrieben wurde.

### Bezugszeichenliste

- 1: Halbleitersubstrat
- 2: Wanne für vertikalen Kondensator
- 3: Wanne für lateralen Kondensator
- 4: dielektrische Schicht
- 5: elektrisch leitfähiges Material
- 6: Metallisierung
- 7: Kontaktelektrode
- 8: p⁺-Kontakt oder n⁺-Kontakt
- 9: Rückseitenmetallisierung
- 10: n⁺-dotierte Wanne
- 11: Randabschluss

## Patentansprüche

1. Elektrische Schaltungsanordnung, die durch ein monolithisch in ein Halbleitersubstrat (1) integriertes RC-Snubberglied gebildet ist, bei der
- ein erster Kondensator (Cᵥₑᵣₜ) und ein Widerstand (R) des RC-Snubberglieds vertikal in einem Halbleitergebiet eines ersten Dotierungstyps des Halbleitersubstrats (1) ausgebildet sind, und
- wenigstens ein weiterer Kondensator (Cₗₐₜ) in Reihe mit dem ersten Kondensator (Cᵥₑᵣₜ) verschaltet ist,
**dadurch gekennzeichnet, dass**
- der weitere Kondensator (Cₗₐₜ) lateral zum ersten Kondensator in ein Halbleitergebiet (3) eines zweiten Dotierungstyps des Halbleitersubstrats (1) integriert ist,
- wobei der zweite Dotierungstyp unterschiedlich zum ersten Dotierungstyp ist,
und das Halbleitergebiet des zweiten Dotierungstyps an das Halbleitergebiet des ersten Dotierungstyps angrenzt und durch den unterschiedlichen Dotierungstyp den weiteren Kondensator (Cₗₐₜ) von dem Halbleitergebiet des ersten Dotierungstyps elektrisch isoliert.

2. Elektrische Schaltungsanordnung nach Anspruch 1, **dadurch gekennzeichnet,**
**dass** das Halbleitergebiet des zweiten Dotierungstyps als Wannengebiet (3) in dem Halbleitergebiet des ersten Dotierungstyps ausgebildet ist.

3. Elektrische Schaltungsanordnung nach Anspruch 1 oder 2, **dadurch gekennzeichnet,**
**dass** sich das Halbleitergebiet des ersten Dotierungstyps von einer Vorderseite des Halbleitersubstrats (1), an der die Kondensatoren (C_{vertf}, Cₗₐₜ) ausgebildet sind, bis zu einer Rückseite des Halbleitersubstrats (1) erstreckt, wobei die Rückseite mit einer Rückseitenmetallisierung (9) versehen ist, über die der Widerstand (R) des RC-Snubbergliedes elektrisch kontaktierbar ist, und an der Vorderseite wenigstens ein elektrischer Kontakt (7) aufgebracht ist, über den wenigstens der weitere Kondensator (Cₗₐₜ) elektrisch kontaktierbar ist.

4. Elektrische Schaltungsanordnung nach Anspruch 3, **dadurch gekennzeichnet,**
**dass** das Halbleitersubstrat (1) zur Bildung der Kondensatoren (Cᵥₑᵣₜ, Cₗₐₜ) auf der Vorderseite jeweils eine Anordnung von Vertiefungen aufweist, die mit einer elektrisch isolierenden dielektrischen Schicht (4) oder Schichtfolge beschichtet und mit einem elektrisch leitfähigen Material (5) aufgefüllt sind.

5. Elektrische Schaltungsanordnung nach Anspruch 4, **dadurch gekennzeichnet,**
**dass** die elektrisch isolierende dielektrische Schicht (4) oder Schichtfolge als eine für die Kondensatoren (Cᵥₑᵣₜ, Cₗₐₜ) gemeinsame elektrisch isolierende dielektrische Schicht (4) oder Schichtfolge ausgebildet ist.

6. Elektrische Schaltungsanordnung nach Anspruch 4 oder 5,
**dadurch gekennzeichnet,**
**dass** die elektrisch isolierende dielektrische Schicht (4) oder Schichtfolge aus Siliciumdioxid und Siliciumnitrid gebildet ist.

7. Elektrische Schaltungsanordnung nach einem der Ansprüche 1 bis 6,
**dadurch gekennzeichnet,**
**dass** zwischen den Kondensatoren (Cᵥₑᵣₜ, Cₗₐₜ) Symmetrierwiderstände ausgebildet sind.

8. Elektrische Schaltungsanordnung nach einem der Ansprüche 2 bis 7 in Verbindung mit Anspruch 2, **dadurch gekennzeichnet,**
**dass** um das Wannengebiet (3) ein Randabschluss (11) ausgebildet ist.

9. Elektrische Schaltungsanordnung nach einem der Ansprüche 1 bis 8,
**dadurch gekennzeichnet,**
**dass** die Halbleitergebiete im Bereich der Kondensatoren (Cᵥₑᵣₜ, Cₗₐₜ) eine Dotierung von ≥ 5E18cm⁻³ aufweisen.

## Claims

1. Electrical circuit arrangement formed by a RC snubber integrated monolithically in a semiconductor substrate (1), in which
- a first capacitor (Cᵥₑᵣₜ) and a resistor (R) of the RC snubber are embodied vertically in a semiconductor region of a first doping type of the semiconductor substrate (1), and
- at least one further capacitor (Cₗₐₜ) is connected in series with the first capacitor (Cᵥₑᵣₜ),
**characterized in that**
- the further capacitor (Cₗₐₜ) is integrated laterally to the first capacitor in a semiconductor region (3) of a second doping type of the semiconductor substrate (1),
- wherein the second doping type is different from the first doping type,
and the semiconductor region of the second doping type adjoins the semiconductor region of the first doping type, and electrically insulates the further capacitor (Cₗₐₜ) from the semiconductor region of the first doping type because of the different doping type.

2. Electrical circuit arrangement according to Claim 1, **characterized in that**
the semiconductor region of the second doping type is designed as a well region (3) in the semiconductor region of the first doping type.

3. Electrical circuit arrangement according to Claim 1 or 2,
**characterized in that**
the semiconductor region of the first doping type extends from a front side of the semiconductor substrate (1), on which the capacitors (Cᵥₑᵣₜ, Cₗₐₜ) are formed, to a rear side of the semiconductor substrate (1), wherein the rear side is furnished with a rear side metallisation (9), via which the resistor (R) of the RC snubber is electrically contactable, and at least one electrical contact (7) is installed on the front side, via which at least the further capacitor (Cₗₐₜ) is electrically contactable.

4. Electrical circuit arrangement according to Claim 3, **characterized in that**
the front side of the semiconductor substrate (1) is furnished with an arrangement of recesses for forming each of the capacitors (Cᵥₑᵣₜ, Cₗₐₜ) , which recesses are coated with an electrically insulating dielectric layer (4) or sequence of layers and filled with an electrically conductive material (5).

5. Electrical circuit arrangement according to Claim 4, **characterized in that**
the electrically insulating dielectric layer (4) or sequence of layers is designed as a shared electrically insulating dielectric layer (4) or sequence of layers for the capacitors (Cᵥₑᵣₜ, Cₗₐₜ) .

6. Electrical circuit arrangement according to Claim 4 or 5,
**characterized in that**
the electrically insulating dielectric layer (4) or sequence of layers is made from silicon dioxide and silicon nitride.

7. Electrical circuit arrangement according to any one of Claims 1 to 6,
**characterized in that**
symmetry resistors are designed between the capacitors (Cᵥₑᵣₜ, Cₗₐₜ) .

8. Electrical circuit arrangement according to any one of Claims 2 to 7 in conjunction with Claim 2,
**characterized in that**
a border lip (11) is constructed around the well region (3) .

9. Electrical circuit arrangement according to any one of Claims 1 to 8,
**characterized in that**
the semiconductor regions have a doping of ≥ 5E18cm⁻³ in the area of the capacitors (Cᵥₑᵣₜ, Cₗₐₜ) .

## Revendications

1. Agencement de circuit électrique qui est formé par un élément d'amortissement RC intégré de manière monolithique dans un substrat semi-conducteur (1), dans lequel
- un premier condensateur (Cᵥₑᵣₜ) et une résistance (R) de l'élément d'amortissement RC sont agencés verticalement dans une région semi-conductrice d'un premier type de dopage du substrat semi-conducteur (1), et
- au moins un autre condensateur (Cₗₐₜ) est connecté en série au premier condensateur (Cᵥₑᵣₜ),
**caractérisé en ce que**
- l'autre condensateur (Cₗₐₜ) est intégré latéralement au premier condensateur dans une région semi-conductrice (3) d'un deuxième type de dopage du substrat semi-conducteur (1),
- dans lequel le deuxième type de dopage est différent du premier type de dopage, et la région semi-conductrice du deuxième type de dopage est contiguë à la région semi-conductrice du premier type de dopage adjacent et isole électriquement par le type de dopage différent le condensateur supplémentaire (Cₗₐₜ) de la région semi-conductrice du premier type de dopage.

2. Agencement de circuit électrique selon la revendication 1, **caractérisé en ce que** la région semi-conductrice du deuxième type de dopage est formée comme une région de puits (3) dans la région semi-conductrice du premier type de dopage.

3. Agencement de circuit électrique selon la revendication 1 ou 2, **caractérisé en ce que** la région semi-conductrice du premier type de dopage d'un côté avant du substrat semi-conducteur (1), sur lequel les condensateurs (Cᵥₑᵣₜ, Cₗₐₜ) sont formés, s'étend jusqu'à un côté arrière du substrat semi-conducteur (1), dans lequel le côté arrière est pourvu d'une métallisation de face arrière (9), via laquelle la résistance (R) de l'élément d'amortissement RC peut être contactée électriquement, et au moins un contact électrique (7) est appliqué sur le côté avant, via lequel au moins l'autre condensateur (Cₗₐₜ) peut être contacté électriquement.

4. Agencement de circuit électrique selon la revendication 3, **caractérisé en ce que** le substrat semi-conducteur (1) pour former les condensateurs (C_{vertf}, Cₗₐₜ) présente sur le côté avant respectivement un réseau d'évidements, qui sont recouverts d'une couche diélectrique électriquement isolante (4) ou d'une séquence de couches et sont remplis d'un matériau électriquement conducteur (5).

5. Agencement de circuit électrique selon la revendication 4, **caractérisé en ce que** la couche diélectrique électriquement isolante (4) ou la séquence de couches est configurée comme une couche diélectrique électriquement isolante commune (4) pour les condensateurs (Cᵥₑᵣₜ, Cₗₐₜ) ou comme une séquence de couches.

6. Agencement de circuit électrique selon la revendication 4 ou 5, **caractérisé en ce que** la couche diélectrique électriquement isolante (4) ou la séquence de couches est formée de dioxyde de silicium et de nitrure de silicium.

7. Agencement de circuit électrique selon une des revendications 1 à 6, **caractérisé en ce que** des résistances d'équilibrage sont formées entre les condensateurs (Cᵥₑᵣₜ, Cₗₐₜ) .

8. Agencement de circuit électrique selon une des revendications 2 à 7 en liaison avec la revendication 2, **caractérisé en ce qu'**une terminaison de bord (11) est formée autour de la zone de puits (3).

9. Disposition du circuit électrique selon une des revendications 1 à 8, **caractérisé en ce que** les zones semi-conductrices dans la zone des condensateurs (C_{vertf}, Cₗₐₜ) présentent un dopage de ≥ 5E18cm⁻³.
